Europäisches Patentamt

European Patent Office

Office européen des brevets

(19)

(11) Veröffentlichungsnummer: **0 176 871**

**A2**

(12) # EUROPÄISCHE PATENTANMELDUNG

(21) Anmeldenummer: **85111802.6**

(22) Anmeldetag: **18.09.85**

(51) Int. Cl.⁴: **G 03 F 7/08**
**G 03 F 7/20**

(30) Priorität: **01.10.84 US 655824**

(43) Veröffentlichungstag der Anmeldung:
**09.04.86 Patentblatt 86/15**

(84) Benannte Vertragsstaaten:
**AT BE CH DE FR GB IT LI NL SE**

(71) Anmelder: **AMERICAN HOECHST CORPORATION**
**Route 202-206 North**
**Somerville, N.J. 08876(US)**

(72) Erfinder: **DiCarlo, John**
**16 Chandler Drive**
**Coventry, RI 02816(US)**

(72) Erfinder: **Mammato, Donald**
**R.D. No.1**
**Lebanon, N.J. 08833(US)**

(72) Erfinder: **Alban, Jonas St.**
**P.O. Box 43**
**Coventry, RI 02816(US)**

(72) Erfinder: **Stevens, Bruce**
**1950 Mountain Avenue**
**Somerville, N.J. 08876(US)**

(74) Vertreter: **Euler, Kurt Emil, Dr. et al,**
**KALLE Niederlassung der Hoechst AG Rheingaustrasse**
**190 Postfach 3540**
**D-6200 Wiesbaden 1(DE)**

(54) **Verfahren zur Herstellung eines Photoresists.**

(57) Es wird ein Verfahren zur Herstellung eines Photoresists beschrieben, bei dem auf einen Schichtträger eine Photoresistschicht, die einen Novolak und einen 1,2-Naphthochinon-2-diazid-4-sulfonsäureester des 2,3,4-Trihydroxy-benzophenons enthält, aufgebracht, bildmäßig mit UV-Licht, dessen Wellenlänge im wesentlichen unterhalb 380 nm liegt, belichtet und mit einer wäßrig-alkalischen Lösung entwickelt wird. Das Verfahren ergibt eine hohe Lichtempfindlichkeit bei hoher Bildauflösung und Entwicklerresistenz.

EP 0 176 871 A2

AMERICAN HOECHST CORPORATION
Somerville, N.J. 08876/USA

84/K102                    - 1 -                    17. September 1985
                                                    WLK-Dr.N.-ur

Verfahren zur Herstellung eines Photoresists

Die Erfindung betrifft ein Verfahren zur Herstellung eines Photoresists aus einem Gemisch, das Novolak und Naphthochinondiazide enthält, durch Belichten im mittleren UV-Bereich.

Die Herstellung von positiv arbeitenden Photoresistgemischen, wie sie z. B. in den US-A 3 666 473, 4 115 128 und 4 173 470 beschrieben sind, ist bekannt. Diese Gemische enthalten alkalilösliche Phenolformaldehyd-Novolake in Verbindung mit lichtempfindlichen Substanzen, gewöhnlich einer substituierten Naphthochinondiazidverbindung. Die Harze und Sensibilisatoren werden in einem organischen Lösemittel oder Lösemittelgemisch gelöst und als dünner Film oder dünne Schicht auf einen für den vorgesehenen Verwendungszweck geeigneten Träger aufgebracht.

Die Novolakkomponente dieser Photoresistgemische ist in wäßrig-alkalischen Lösungen löslich, wogegen durch Zusatz von Naphthochinondiazid diese Löslichkeit herabgesetzt wird. Bei der Belichtung von bestimmten Bereichen des beschichteten Trägers mit aktinischer Strahlung erfährt der Sensibilisator jedoch eine durch die Strahlung induzierte strukturelle Umwandlung, und die belichteten Bereiche der Schicht werden löslicher als die unbelichteten Bereiche. Durch diesen Löslichkeitsunterschied lösen sich die belichteten Bereiche der

AMERICAN HOECHST CORPORATION
Somerville, N.J. 08876/USA

- 2 -

Photoresistschicht, wenn sie in eine alkalische Entwicklerlösung getaucht wird, während die nicht belichteten Bereiche weitgehend unbeeinflußt bleiben. Auf
diese Weise entsteht auf dem Träger ein positives
Reliefmuster.

In den meisten Fällen wird der bei der Entwicklung
freigelegte Träger mit einer Ätzlösung behandelt. Dabei wird auf dem Träger ein Ätzmuster entsprechend der
bei der Belichtung verwendeten Maske, Schablone usw.
erzeugt.

Das nach dem oben beschriebenen Verfahren hergestellte
Reliefbild aus Photoresist auf dem Träger eignet sich
für verschiedene Anwendungszwecke, zum Beispiel als
Belichtungsmaske oder -vorlage bei der Herstellung von
miniaturisierten integrierten elektronischen
Schaltkreisen.

Für die Nutzung eines Photoresists wichtige Eigenschaften sind: Lichtempfindlichkeit, Entwicklungskontrast,
Auflösung und Haftung auf dem Träger.

Eine erhöhte Lichtempfindlichkeit ist wichtig für einen
Photoresist, insbesondere wenn er für Anwendungen eingesetzt wird, bei denen mehrere Belichtungen erforderlich sind, z. B. bei der Erzeugung von Mehrfachbildern
durch schrittweise Belichtung oder in Fällen, in denen
Licht mit geringerer Intensität verwendet wird, z. B.
bei der Projektionsbelichtung, bei der das Licht eine

0176871

AMERICAN HOECHST CORPORATION
Somerville, N.J. 08876/USA

- 3 -

Reihe von Objektiven und monochromatischen Filtern durchläuft. Eine erhöhte Lichtempfindlichkeit ist ganz besonders wichtig für ein Resistgemisch, das in Verfahren eingesetzt wird, bei denen Mehrfachbelichtungen durchgeführt werden müssen, um eine Serie von Schaltbildern auf einem Träger zu erzeugen. Optimale Bedingungen erfordern eine gleichbleibende Entwicklungstemperatur und -zeit bei einer bestimmten Entwicklungsart sowie ein Entwicklersystem, das so ausgewählt ist, daß ein vollständiges Ausentwickeln der belichteten Resistbereiche erreicht und gleichzeitig der Dickenverlust der unbelichteten Resistbereiche auf höchstens etwa 10 % der anfänglichen Dicke begrenzt wird.

Unter Entwicklungskontrast ist das Verhältnis des prozentualen Schichtverlusts im belichteten Bereich zu dem prozentualen Schichtverlust im unbelichteten Bereich nach dem Entwickeln zu verstehen. Normalerweise wird ein mit einem belichteten Resist beschichteter Träger so lange entwickelt, bis die Schicht im belichteten Bereich sich im wesentlichen vollständig abgelöst hat. Der Entwicklungskontrast kann daher dadurch bestimmt werden, daß nach dem vollständigen Ablösen der belichteten Schichtbereiche einfach der prozentuale Schichtverlust in den unbelichteten Bereichen gemessen wird.

Unter Auflösung des Resists versteht man die Fähigkeit eines Resistsystems zur Wiedergabe der feinsten, im gleichen Abstand voneinander angeordneten Linienpaare und der kleinsten zugehörigen Zwischenräume einer für

AMERICAN HOECHST CORPORATION
Somerville, N.J. 08876/USA

- 4 -

die Belichtung verwendeten Vorlage mit einem hohen
Grad an Kantenschärfe des Bildes.

Für viele technische Anwendungen, insbesondere für die
Herstellung von miniaturisierten elektronischen Komponenten, muß ein Photoresist eine hohe Auflösung aufweisen, d. h. er muß sehr kleine Linien- und Zwischenraumbreiten in der Größenordnung von 1 µm oder darunter
wiedergeben.

Die Fähigkeit eines Resists zur Wiedergabe derartig
kleiner Abmessungen ist bei der Herstellung von LSI-
Schaltungen auf Siliciumchips und ähnlichen Komponenten
von größter Bedeutung. Die Schaltungsdichte auf einem
solchen Chip kann nur durch eine Steigerung des Auflösungsvermögens des Resists - vorausgesetzt, es wird
mit photolithographischen Verfahren gearbeitet - erhöht werden.

Eine Möglichkeit zur Steigerung des Auflösungsvermögens
eines Resists ist die Belichtung mit kürzerwelligem
Licht. Belichtungen mit einer Strahlung im mittleren
UV-Bereich (etwa 295 - 380 nm) ergeben zum Beispiel
eine um etwa 0,25 µm bessere Auflösung als Belichtungen
im nahen UV-Bereich (etwa 380 - 495 nm). Allerdings ist
es bisher nicht möglich gewesen, einen Sensibilisator
mit ausreichender Lichtempfindlichkeit und ausreichendem Kontrast im mittleren UV-Bereich zu finden.

AMERICAN HOECHST CORPORATION
Somerville, N.J. 08876/USA

- 5 -

Aus der EP-A 92 444 ist eine Photoresistlösung bekannt,
die als lichtempfindlichen Bestandteil ein Gemisch von
Estern unterschiedlichen Veresterungsgrads von Di- oder
Trihydroxyphenylketonen, z. B. 2,3,4-Trihydroxybenzophenon, mit den 4- oder 5-Sulfonsäuren des 1,2-Naphthochinon-2-diazids oder 1,2-Benzochinondiazids enthält.
In den Ausführungsbeispielen werden allein Ester der
1,2-Naphthochinon-2-diazid-5-sulfonsäure mit verschiedenen Polyhydroxyphenylketonen beschrieben. Die Belichtung erfolgt mit üblichem, also langwelligem Ultraviolettlicht.

Aufgabe der Erfindung war es, ein Verfahren zur Herstellung von Positiv-Photoresists durch Belichten
einer positiv arbeitenden Photoresistschicht mit Strahlung im mittleren UV-Bereich vorzuschlagen, das kurze
Belichtungszeiten erlaubt und Resistmuster mit hoher
Auflösung und hoher Resistenz gegen wäßrig-alkalische
Entwickler und gegen Plasmaätzen ergibt.

Erfindungsgemäß wird ein Verfahren zur Herstellung
eines Photoresists vorgeschlagen, bei dem auf einen
Schichtträger eine Photoresistschicht, die einen Novolak und einen 1,2-Naphthochinon-2-diazid-sulfonsäureester des 2,3,4-Trihydroxy-benzophenons enthält, aufgebracht, bildmäßig belichtet und mit einer wäßrig-
alkalischen Lösung entwickelt wird.

AMERICAN HOECHST CORPORATION
Somerville, N.J. 08876/USA


- 6 -


Das erfindungsgemäße Verfahren ist dadurch gekennzeichnet, daß man einen Ester der 1,2-Naphthochinon-2-diazid-4-sulfonsäure einsetzt und die Belichtung mit UV-Licht vornimmt, dessen Wellenlänge im wesentlichen unterhalt 380 nm liegt.

Gegenüber bekannten positiv arbeitenden Photoresists weisen die erfindungsgemäßen Photoresistgemische nicht nur eine erhöhte Lichtempfindlichkeit und gesteigerten Kontrast im mittleren UV-Bereich, sondern auch eine hohe Auflösung und gute Haftungseigenschaft auf.

Das für den Einsatz bei dem erfindungsgemäßen Verfahren bevorzugte Gemisch enthält ein Novolakharz, den Ester aus 3 mol 1,2-Naphthochinon-2-diazid-4-sulfonsäure und 1 mol 2,3,4-Trihydroxy-benzophenon als Photosensibilisator sowie ein geeignetes Lösemittel.

Die Herstellung der in lichtempfindlichen Gemischen verwendbaren Novolake ist bekannt. Ein Verfahren zu ihrer Herstellung ist (z. B.) in "Chemistry and Application of Phenolic Resins", von A. Knop und W. Scheib, Springer Verlag, New York, 1979, Kapitel 4, beschrieben.

Das Lösemittel wird je nach dem vorgesehenen Beschichtungsverfahren, der gewünschten Schichtdicke und den Trocknungsbedingungen gewählt. Zu den für das erfindungsgemäße Gemisch geeigneten Lösemitteln zählen Ether (z. B. Tetrahydrofuran), Alkohole (z. B. n-Propanol),

AMERICAN HOECHST CORPORATION
Somerville, N.J. 08876/USA

- 7 -

Alkoholether (z. B. Ethylenglykolmonoethylether), Ester (z. B. Butylacetat), aromatische oder aliphatische Kohlenwasserstoffe (z. B. Xylol); es können aber auch Lösemittelgemische verwendet werden. Grundsätzlich sind alle Lösemittel geeignet, die mit den Schichtbestandteilen nicht irreversibel reagieren. Besonders bevorzugt werden Partialether von Glykolen, insbesondere Ethylen- oder Propylenglykolmonoethylether oder deren Ester. Ein vorzugsweise verwendetes Lösemittel ist 1-Methoxy-prop-2-ylacetat.

In dem lichtempfindlichen Gemisch wird ein Naphthochinondiazid eingesetzt, das nach einem Verfahren, ähnlich dem aus der US-A 3 046 118 bekannten Verfahren, synthetisiert werden kann. Die Herstellung läßt sich wie folgt beschreiben:

In einen lichtgeschützten 2 1-Kolben werden 11,5 g 2,3,4-Trihydroxy-benzophenon, 44,5 g 1,2-Naphthochinon-2-diazid-4-sulfonylchlorid und 300 ml Dioxan gegeben. Über einen Zeitraum von etwa 5 Minuten werden unter Rühren 250 ml einer 10 %-igen wäßrigen Natriumcarbonatlösung hinzugefügt. Nach weiterem fünfzehnminütigem Rühren werden unter Rühren langsam 87,5 ml einer 15 %-igen wäßrigen Salzsäurelösung und dann 750 ml Wasser zugesetzt. Das als teerartige Masse ausgefällte Produkt wird noch eine Stunde gerührt, abfiltriert und mit Wasser gewaschen. Das isolierte Produkt wird in 250 ml einer 5 %-igen wäßrigen Dinatriumphosphatlösung aufgeschlämmt und über Nacht gerührt, danach filtriert

AMERICAN HOECHST CORPORATION
Somerville, N.J. 08876/USA

- 8 -

.und mit Wasser neutral gewaschen. Es wird dann in
225 ml Ethanol aufgeschlämmt, zweieinhalb Stunden
gerührt, filtriert und mit 250 ml Ethanol gewaschen.
Anschließend wird das Produkt in Wasser aufgeschlämmt,
filtriert und so lange mit Wasser gewaschen, bis das
Filtrat klar ist. Das Produkt wird schließlich getrocknet.

Ausbeute: 28,8 g, 62,2 % d. Th.
Aussehen: bräunliches Pulver.

In der bevorzugten Ausführung beträgt der Anteil der
festen Bestandteile, d. h. Novolak und Chinondiazid, in
dem Photoresistgemisch etwa 75 - 99 % Novolakharz und
etwa 1 - 25 % Chinondiazid. Der Anteil an Novolakharz
liegt vorzugsweise bei etwa 80 - 90, insbesondere bei
etwa 82 - 85 Gew.-%, bezogen auf die festen Resistbestandteile. Der Anteil an Chinondiazid liegt vorzugsweise bei etwa 10 - 20, insbesondere bei etwa 15 - 18
Gew.-%, bezogen auf die festen Resistbestandteile. Bei
der Herstellung des Resistgemischs werden Novolak und
Chinondiazid mit einem Lösemittel so gemischt, daß der
Lösemittelanteil etwa 50 - 90 Gew.-% der Resistlösung
ausmacht. Vorzugsweise beträgt der Lösemittelanteil
etwa 70 - 80, insbesondere etwa 74 - 76 Gew.-%. Die
Chinondiazidkomponente des Resistgemischs enthält den
Ester aus 3 mol 1,2-Naphthochinon-2-diazid-4-sulfonsäure und 1 mol 2,3,4-Trihydroxy-benzophenon; vorzugsweise besteht die Chinondiazidkomponente im wesentlichen aus dieser Verbindung. Der Begriff "besteht

AMERICAN HOECHST CORPORATION
Somerville, N.J. 08876/USA

- 9 -

im wesentlichen aus" bedeutet hier, daß weniger als 10 %, insbesondere wesentlich weniger als 10 %, der Chinondiazidkomponente aus anderen Chinondiaziden besteht. In der am meisten bevorzugten Ausführung besteht die Chinondiazidkomponente ausschließlich aus dieser speziellen Verbindung.

Der Lösung aus Novolak, Sensibilisator und Lösemittel können vor dem Aufbringen auf einen Träger noch Zusätze, z. B. Pigmente, Farbstoffe, Verlaufmittel, Weichmacher, Haftvermittler, Entwicklungsbeschleuniger, Lösemittel und Tenside, z. B. nicht-ionische Tenside, zugegeben werden.

Farbstoffe, die den Photoresistgemischen zugesetzt werden können, sind zum Beispiel Methylviolett 2 B (C.I. 42 535), Kristallviolett (C.I. 42 555), Malachitgrün (C.I. 42 000), Viktoriablau B (C.I. 44 045) und Neutralrot (C.I. 50 040), die in einer Menge von 1 bis 10 Gew.-%, bezogen auf das Gesamtgewicht von Novolak und Sensibilisator, zugesetzt werden. Die Farbstoffzusätze vermindern die Lichtstreuung am Träger und tragen so zu einer verbesserten Auflösung bei.

Verlaufmittel können in einer Menge bis zu 5 Gew.-%, bezogen auf das Gesamtgewicht von Novolak und Sensibilisator, eingesetzt werden.

Geeignete Weichmacher sind zum Beispiel Phosphorsäuretris-(ß-chlorethyl)-ester, Stearinsäure, Campher, Poly-

AMERICAN HOECHST CORPORATION
Somerville, N.J. 08876/USA

- 10 -

propylen, Acetalharze, Phenoxyharze und Alkydharze, die in Anteilen von 1 bis 10 Gew.-%, bezogen auf das Gesamtgewicht von Novolak und Sensibilisator, zugesetzt werden können. Die Weichmacherzusätze verbessern die Beschichtungseigenschaften des Materials und ermöglichen das Auftragen einer glatten und gleichmäßig dicken Schicht auf den Träger.

Geeignete Haftvermittler sind zum Beispiel ß-(3,4-Epoxycyclohexyl)-ethyltrimethoxysilan, p-Methyldisilanmethylmethacrylat, Vinyltrichlorsilan und $\gamma$-Aminopropyltriethoxysilan, in einem Anteil bis zu 4 Gew.-%, bezogen auf das Gesamtgewicht von Novolak und Sensibilisator.

Als Entwicklungsbeschleuniger können beispielsweise Pikrinsäure, Nikotinsäure oder Nitrozimtsäure in einem Anteil bis zu 20 Gew.-%, bezogen auf das Gesamtgewicht von Novolak und Sensibilisator, zugegeben werden. Diese Beschleuniger führen dazu, daß die Löslichkeit der Photoresistschicht sowohl in den belichteten als auch in den unbelichteten Bereichen zunimmt, und sie werden deshalb bei solchen Anwendungen eingesetzt, bei denen es in erster Linie auf die Entwicklungsgeschwindigkeit ankommt, auch wenn dabei evtl. ein gewisser Grad an Kontrast geopfert wird. Dabei werden zwar die belichteten Bereiche der Photoresistschicht vom Entwickler schneller gelöst, gleichzeitig bewirken die Entwicklungsbeschleuniger aber auch einen größeren Verlust an Photoresistschicht aus den unbelichteten Bereichen.

AMERICAN HOECHST CORPORATION
Somerville, N.J. 08876/USA

- 11 -

Als Lösemittel sind u. a. Xylol, Butylacetat und Ethylenglykolmonomethyletheracetat geeignet.

Als nicht-ionische Tenside können zum Beispiel Nonylphenoxypoly(ethoxy)-ethanol, Octylphenoxyethoxyethanol und Dinonylphenoxy-poly(ethoxy)-ethanol in einem Anteil bis zu 10 Gew.-%, bezogen auf das Gesamtgewicht von Novolak und Sensibilisator, verwendet werden.

Die so hergestellte Resistlösung kann nach einem der in der Photoresisttechnik üblichen Verfahren, wie Tauchen, Sprühen oder Aufschleudern, auf einen Träger aufgebracht werden. Beim Aufschleudern kann z. B. der Prozentanteil an Feststoffen in der Resistlösung so eingestellt werden, daß sich bei dem verwendeten Beschichtungsgerät und der für das Aufschleudern angesetzten Zeitspanne eine Schicht in der gewünschten Dicke ergibt.

Die nach dem oben beschriebenen Verfahren herzustellenden Photoresistschichten eignen sich insbesondere zum Auftragen auf Silicium-Wafer, die eine Schicht aus thermisch gezüchtetem Siliciumdioxid tragen, wie sie bei der Herstellung von Mikroprozessoren und anderen Komponenten für miniaturisierte integrierte Schaltungen verwendet werden. Ebenso kann auch ein Wafer aus Aluminium/Aluminiumoxid verwendet werden. Der Träger kann ferner aus verschiedenen polymeren Harzen, insbesondere aus transparenten Polymeren, z. B. Polyestern, oder auch aus dotiertem Siliciumdioxid,
Siliciumnitrid, Tantal, Kupfer, polykristallinem
Silicium (polysilicon), Keramik und Aluminium/Kupfer-
Legierungen bestehen.

Nach dem Auftragen der Beschichtungslösung auf den
Träger wird der Träger auf etwa 80 - 90° C nacherhitzt,
bis sich das Lösemittel im wesentlichen vollständig
verflüchtigt hat und nur eine Schicht aus dem Photoresistgemisch in einer Dicke im Bereich von 1 μm auf
dem Träger zurückbleibt. Auf den beschichteten Träger
kann dann mit aktinischer Strahlung, insbesondere mit
UV-Strahlung im Bereich unterhalb 380 nm, vorzugsweise
bei 295-380 nm, jedes gewünschte Belichtungsmuster aufbelichtet werden, das mit Hilfe von geeigneten Photomasken, Negativen, Schablonen, Projektionsgeräten usw.
erzeugt wird. In einer bevorzugten Ausführung rangiert
der UV-Belichtungsbereich zwischen etwa 295 und 350 nm,
insbesondere bei 295 - 325 nm.

Anschließend werden die belichteten Materialien in eine
alkalische Entwicklerlösung eingetaucht. Die Lösung
wird vorzugsweise bewegt, z. B. durch Einblasen von
Stickstoff. Die Träger werden so lange in dem Entwickler belassen, bis die gesamte bzw. im wesentlichen die
gesamte Resistschicht aus den belichteten Bereichen
weggelöst ist.

Nach dem Herausnehmen der beschichteten Wafer aus der
Entwicklerlösung kann eine Nacherhitzung durchgeführt

AMERICAN HOECHST CORPORATION
Somerville, N.J. 08876/USA

- 13 -

werden, um die Haftung der Schicht auf dem Träger und
ihre chemische Beständigkeit gegen Ätzlösungen und
andere Substanzen zu erhöhen. Die Wärmebehandlung nach
dem Entwickeln kann aus einer Ofenhärtung von Schicht
und Träger bei Temperaturen unterhalb des Erweichungspunkts der Schicht bestehen. Bei technischen Anwendungen, insbesondere bei der Herstellung von miniaturisierten Schaltungen auf Silicium/Siliciumdioxid-Trägern
können die entwickelten Träger mit einer gepufferten
Ätzlösung auf der Basis von Fluorwasserstoffsäure behandelt werden. Die erfindungsgemäßen Resistgemische
sind beständig gegen saure Ätzlösungen, so daß die
in den unbelichteten Bereichen verbleibende Resistschicht einen wirksamen Schutz des Trägers gewährleistet.

In den folgenden Beispielen wird die Herstellung und
Anwendung von lichtempfindlichen Gemischen nach dem
erfindungsgemäßen Verfahren erläutert.

Beispiel 1 (Vergleichsbeispiel)
Zwei Photoresistlösungen werden wie folgt hergestellt:

| Resist A | | Resist B | |
|---|---|---|---|
| Novolak | 22,9 % | Novolak | 24,3 % |
| 1-Methoxy-2-acetoxy-propan | 74,0 % | 1-Methoxy-2-acetoxy-propan | 73,0 % |

**0176871**

AMERICAN HOECHST CORPORATION
Somerville, N.J. 08876/USA

- 14 -

Resist A

Ester aus 3 mol 1,2-Naphthochinon-
2-diazid-4-sulfonsäure und 1 mol
2,3,4-Trihydroxy-
benzophenon          3,1 %

Resist B

Ester aus 3 mol 1,2-Naphthochinon-
2-diazid-5-sulfon-
säure und 1 mol
2,3,4-Trihydroxy-
benzophenon          2,7 %

Novolakharz und Lösemittel sind in Photoresist A und Photoresist B die gleichen. Der Anteil an photoaktiver Komponente, und damit der Diazo-Stickstoffgehalt, ist vergleichbar.

Das Harz wird in dem Lösemittel gelöst, wobei über Nacht gerührt wird; anschließend wird die photoaktive Komponente gelöst und die Lösung durch ein 0,2 um-Millipore Teflonfilter filtriert.

Beurteilung von Lichtempfindlichkeit, Kontrast und Dickenverlust der unbelichteten Schicht

Die Photoresistlösungen werden mit einer konstanten Schleudergeschwindigkeit auf mehrere Wafer aufgeschleudert. Dann werden die Wafer 30 Minuten bei 90° C nacherhitzt. Die anfänglichen Schichtdicken der aufgebrachten Photoresists werden mit einem Rudolf-Schichtdickenmeßgerät gemessen. Zur Messung der Lichtempfindlichkeit wird eine Kontrastkurve aufgetragen, wie in "Introduction to Microlithography" von

AMERICAN HOECHST CORPORATION
Somerville, N.J. 08876/USA

- 15 -

G. C. Willson, Kapitel 3, S. 105, American Chemical
Society, Washington, D.C., 1983, beschrieben. Dazu
wird der Schichtdickenverlust nach einminütigem Entwickeln gegen den Logarithmus der UV-Belichtungsdosis
aufgetragen. Die Schichtdicke wird durch Laser-Interferometrie gemessen. Anschließend wird mit einer wäßrigen, mit Kaliumborat gepufferten 1,4 n KOH-Lösung,
die mit entionisiertem Wasser im Verhältnis 1 : 4
verdünnt ist, bei 22° C entwickelt. Durch Extrapolation
der Kurve auf den gesamten Schichtdickenverlust erhält
man den Lichtempfindlichkeitswert (mJ/cm$^2$), und die
Steigung dieser Kurve gibt den Kontrast an. Die folgenden Ergebnisse werden für die Photoresists A und B
bei Belichtung im nahen UV-Bereich (380-450 nm) erhalten:

| | Resist A | Resist B |
|---|---|---|
| Lichtempfindlichkeit (mJ/cm$^2$) | 43 | 50 |
| Kontrast | 3,36 | 2,56 |
| anfängliche Schichtdicke (/um) | 1,438 | 1,440 |
| Dickenverlust der unbelichteten Schicht (nm) | 9 | 31 |

Die Ergebnisse zeigen, daß bei Belichtung im nahen UV-
Bereich des Spektrums und bei vergleichbarer Schichtdicke Resist A eine um 16 % höhere Lichtempfindlichkeit
und einen um 31 % höheren Kontrast als Resist B und nur
29 % des Dickenverlusts im Vergleich zu Resist B aufweist.

AMERICAN HOECHST CORPORATION
Somerville, N.J. 08876/USA

- 16 -

Beispiel 2

Beispiel 1 wird wiederholt, wobei jedoch mit einer Wellenlänge im mittleren UV-Bereich (310 nm) belichtet wird. Ferner wird in diesem Beispiel der Entwickler verändert, d. h. es wird das oben angegebene Entwicklerkonzentrat verwendet, das im Verhältnis 3 : 1 mit entionisiertem Wasser verdünnt wurde.

| | Resist A | Resist B |
|---|---|---|
| Lichtempfindlichkeit (mJ/cm$^2$) | 58 | 133 |
| Kontrast | 2,25 | 1,93 |
| anfängliche Schichtdicke (/um) | 1,498 | 1,497 |
| Dickenverlust der unbelichteten Schicht (nm) | 9 | 98 |

Die Ergebnisse zeigen, daß Resist A bei der Belichtung im mittleren UV-Bereich (310 nm) eine deutliche Verbesserung gegenüber dem Resist B aufweist. In diesem Fall hat sich die Lichtempfindlichkeit um 129 % und der Kontrast um 16 % erhöht, und der Dickenverlust der unbelichteten Schicht beträgt nur 9 % des Verlusts von Resist B.

Plasmaätzrate

Die Plasmaätzrate einer unbelichteten Resistschicht soll möglichst niedrig sein. Um die Plasmaätzrate zu prüfen, werden die mit Resist beschichteten Proben bei 120° C 30 Minuten nacherhitzt. Nachfolgend sind die Chlorplasmaätzraten der Resists A und B angegeben.

AMERICAN HOECHST CORPORATION
Somerville, N.J. 08876/USA

- 17 -

Die Prüfbedingungen sind wie folgt: Mit Hexamethyldisilazan bedampfte Wafer, 950 nm Al/2 % Cu aufgesputtert, Dicke jeder Resistschicht 1,6/um, Schichthärtung 120° C/30 Minuten, Ätzung bei 125 Torr, 35° C, 20 Standard-cm$^3$ Cl$_2$, 100 Standard-cm$^3$ BCl$_3$, 1500 W.

|  | Ätzverhältnis (Al : Photoresist) |
|---|---|
| Resist A | 3 : 1 |
| Resist B | 3 : 1 |

Aus diesen Angaben ist ersichtlich, daß beide Resists die gleiche Chlorplasmaätzbeständigkeit haben.

Aufschleuderkurven

Aufschleuderkurven werden verwendet, um anhand der Schleudergeschwindigkeit die Dicke der nacherhitzten Resistschicht im voraus einzustellen. Diese Kurven müssen daher eine gerade Linie bilden, wenn der Logarithmus der Schichtdicke gegen die Schleudergeschwindigkeit aufgetragen wird. Die beiden Photoresists A und B werden jeweils mit verschiedenen Geschwindigkeiten, wie unten angegeben, aufgeschleudert, 30 Minuten bei 90° C nacherhitzt, und die Schichtdicke wird gemessen.

AMERICAN HOECHST CORPORATION
Somerville, N.J. 08876/USA

- 18 -

| U/min | Resist A ($\mu$m) | Resist B ($\mu$m) |
|---|---|---|
| 3000 | 1.596 | 2.400 |
| 4000 | 1.413 | 2.100 |
| 5000 | 1.239 | 1.900 |
| 6000 | 1.116 | 1.700 |
| 7000 | 1.001 | 1.600 |

Wenn die Werte wie oben angegeben aufgetragen werden, ergibt sich für jeden Resist eine weitgehend geradlinige Kurve.

Diese Beispiele verdeutlichen, daß sich beim Einsatz des Esters aus 3 mol 1,2-Naphthochinon-2-diazid-sulfonsäure und 1 mol 2,3,4-Trihydroxy-benzophenon als Sensibilisator ein Photoresist mit erheblich verbesserter Lichtempfindlichkeit im mittleren UV-Bereich ergibt, wobei die anderen wünschenswerten Eigenschaften des Photoresists, wie zum Beispiel hoher Kontrast, hohe Chlorplasmabeständigkeit und hohe Entwicklerresistenz, im wesentlichen erhalten bleiben.

-------

AMERICAN HOECHST CORPORATION
Somerville, N.J. 08876/USA

84/K102                    - 19 -              17. September 1985
                                               WLK-Dr.N.-ur

Patentansprüche

1. Verfahren zur Herstellung eines Photoresists, bei dem auf einen Schichtträger eine Photoresistschicht, die einen Novolak und einen 1,2-Naphthochinon-2-diazid-sulfonsäureester des 2,3,4-Trihydroxy-benzophenons enthält, aufgebracht, bildmäßig belichtet und mit einer wäßrig-alkalischen Lösung entwickelt wird, dadurch gekennzeichnet, daß man einen Ester der 1,2-Naphthochinon-2-diazid-4-sulfonsäure einsetzt und die Belichtung mit UV-Licht vornimmt, dessen Wellenlänge im wesentlichen unterhalb 380 nm liegt.

2. Verfahren nach Anspruch 1, dadurch gekennzeichnet, daß man UV-Licht einer Wellenlänge im Bereich von 295 bis 380 nm verwendet.

3. Verfahren nach Anspruch 1, dadurch gekennzeichnet, daß die Photoresistschicht 75 bis 99 Gew.-% Novolak und 1 bis 25 Gew.-% Naphthochinondiazid enthält.

4. Verfahren nach Anspruch 1, dadurch gekennzeichnet, daß die Photoresistschicht ferner einen Farbstoff enthält.

5. Verfahren nach Anspruch 1, dadurch gekennzeichnet, daß man die Photoresistschicht durch Beschichten aus einer Lösung in einem Glykolpartialether aufbringt.

0176871

AMERICAN HOECHST CORPORATION
Somerville, N.J. 08876/USA

- 20 -

6. Verfahren nach Anspruch 1, dadurch gekennzeichnet, daß die Photoresistschicht auf einen Schichtträger aus Silicium aufgebracht wird.